# EUROPÄISCHE PATENTSCHRIFT

(11) **EP 1 053 582 B1**
(45) Veröffentlichungstag und Bekanntmachung des Hinweises auf die Patenterteilung: **14.11.2001**
(21) Anmeldenummer: 98966406.5
(22) Anmeldetag: 24.12.1998
(51) Int. Cl.: H02B 1/56

(54) **SCHALTSCHRANK**
CONTROL CABINET
ARMOIRE DE COMMANDE

(30) Priorität: 07.02.1998 DE 19804901
(43) Veröffentlichungstag der Anmeldung: 22.11.2000
(73) Patentinhaber: Rittal-Werk Rudolf Loh GmbH & Co. KG, 35745 Herborn (DE)
(72) Erfinder: NICOLAI, Walter, D-35418 Buseck (DE); PAWLOWSKI, Adam, D-35713 Eschenburg-Wissenbach (DE); SCHNEIDER, Stefan, D-35080 Bad Endbach (DE)
(74) Vertreter: Fleck, Hermann-Josef, Dr.-Ing.
(86) Internationale Anmeldenummer: EP9808450
(87) Internationale Veröffentlichungsnummer: WO9940659

(56) Entgegenhaltungen:
- DE-C1- 4 135 894
- DE-U1- 9 315 017

## Beschreibung

Die Erfindung betrifft einen Schaltschrank mit einem Schrankkorpus, dessen offene Korpusseiten zumindest teilweise mit einer oder mehreren Seitenwänden verschließbar sind, wobei im Bereich wenigstens einer Seitenwand eine Klimatisierungseinrichtung angeordnet ist, über die Wärme aus dem Innenraum des Schrankkorpusses abgeführt oder diesem zuleitbar ist.

Ein derartiger Schaltschrank ist aus der DE 41 35 894 C1 bekannt. Dieser Schaltschrank besitzt als Klimatisierungseinrichtung eine Kühleinheit, die Lüfter und Wärmetauscher aufweist. Die Kühleinheit ist in einem Gehäuse untergebracht, das in einen Ausschnitt einer vertikalen Seitenwand eingesetzt ist. Um bei einem bestehenden Schaltschrank die Kühleinheit nachrüsten zu können, muß die entsprechende Seitenwand umgearbeitet, bzw. eine neue eingebaut werden.

In der DE-U-93 15 017 ist ein Schaltschrank gezeigt, der einen Schaltschrankkorpus und einen Schaltschranksockel aufweist. Im Bereich des Schaltschranksockels ist eine Klimatisierungseinrichtung untergebracht. Im Innenraum des Schaltschrankkorpusses ist eine vertikale Montageplatte aufgestellt. Diese vertikale Montageplatte bildet zusammen mit einer Rückwand des Schaltschrankes einen Luftführungskanal. Mittels der Klimatisierungseinrichtung kann die im Schaltschrank-Innenraum gehaltene Luft durch den Luftführungskanal zirkuliert werden. Üblicherweise werden bei Schaltschränken für die Befestigung der Montageplatte horizontale, im Schaltschrank-Tiefenrichtung verlaufende Stützstreben verwendet. Auf diesen sitzt die Montageplatte auf. Zusätzlich werden im Dachbereich oder im Bereich der Seitenwände des Schaltschrankes punktuelle Fixierungen vorgenommen.

Aus der DE 43 13 022 ist eine Klimatisierungseinrichtung bekannt, die an der Außenseite der Seitenwand angebaut ist. Um eine räumliche Verbindung zum Innenraum des Schaltschrankes herzustellen, wird die Seitenwand mit entsprechenden Durchbrüchen versehen.

Die DE 37 10 566 C2 beschreibt eine Klimatisierungseinrichtung, die auf die als Deckelblech ausgebildete Seitenwand aufgesetzt ist. Ähnlich wie bei der DE 43 13 022 müssen aus dem Deckelblech Ausschnitte ausgespart werden.

Es ist Aufgabe der Erfindung, einen Schaltschrank der eingangs erwähnten Art zu schaffen, der auf einfache Weise mit einer Klimatisierungseinrichtung aufgerüstet werden kann.

Die Aufgabe wird dadurch gelöst, daß parallel beabstandet zu der Seitenwand dem Innenraum des Schrankkorpus zugekehrt eine Zwischenwand angeordnet ist, und daß in dem Zwischenraum, der von der Seitenwand und der Zwischenwand umschlossen ist, die Klimatisierungseinrichtung angeordnet ist, daß der Schrankkorpus ein Rahmengestell aufweist, das aus vertikalen Rahmenprofilen und horizontalen Tiefen- und Breitenstreben zusammengesetzt ist, daß die Zwischenwand und die Seitenwand an dem Rahmengestell befestigt sind.

Bei dieser erfindungsgemäßen Ausgestaltung eines Schaltschrankes wird die Seitenwand zu einem Teil der Klimatisierungseinrichtung, wodurch der Teileaufwand erheblich reduziert werden kann. Infolge des Anbaus der Klimatisierungseinrichtung wird auch die äußere Geometrie des Schaltschrankes nicht verändert, was zum einen optische Vorteile bietet. Zum anderen kann dadurch beengten Platzverhältnissen in der Umgebung des Schaltschrankes Rechnung getragen werden. Dadurch, daß die Kühleinrichtung der Seitenwand zugeordnet ist, läßt sich auch Wärmeenergie mit der Umgebung flächig direkt über die Seitenwand austauschen. Dies bewirkt einen guten Wirkungsgrad der Kühleinrichtung.

Nach einer bevorzugten Ausgestaltungsvariante der Erfindung ist es vorgesehen, daß die in Richtung senkrecht zur Seitenwand verlaufende Breite des Zwischenraumes gleich oder kleiner der entsprechenden vertikalen Rahmenprofile oder der Tiefen- bzw. Breitenstreben ist. Die so ausgestaltete Klimatisierungseinrichtung verkleinert den Innenraum des Schaltschrankes kaum, so daß der Bauraum für Einbauten nur geringfügig eingeschränkt wird. Insbesondere können die vertikalen Rahmenprofile noch als Befestigungsstellen für Einbauten verwendet werden.

Die Klimatisierungseinrichtung kann beispielsweise als Wärmetauscher ausgebildet sein. Die Zwischenwand ist dann mit einem oder mehreren Durchbrüchen versehen, über die Luft aus dem Schaltschrank-Innenraum dem Wärmetauscher zugeleitet ist. Die klimatisierte Luft kann anschließend wieder in den Schaltschrank-Innenraum zurückgeführt werden.

Dabei kann es insbesondere vorgesehen sein, daß der Wärmetauscher ein mäanderförmig angeordnetes Leitungssystem aufweist, durch das Kühlflüssigkeit geleitet ist, und das mit Kühlflächen in den von der Zwischen- und der Seitenwand gebildeten Zwischenraum weist, und daß das Leitungssystem über Anschlußstücke an eine außerhalb des Schrankkorpusses angeordnete Versorgungseinheit angeschlossen ist. An dem mäanderförmigen Leitungssystem kann eine effektive Kühlung der Luft erfolgen. Bevorzugt sind die Leitungsabschnitte des Leitungssystemes, die quer zur Strömungsrichtung angeordnet sind, gegeneinander senkrecht zur Seitenwand versetzt angeordnet.

Durch diese einfach Maßnahme wird die strömende Luft in dem Leitungssystem mehrfach umgelenkt, so daß die Leitungsabschnitte optimal umströmt sind.

Eine mögliche Erfindungsvariante ist dadurch gekennzeichnet, daß die vertikale Zwischenwand in ihrem oberen Bereich mit den als Eintrittsöffnungen ausgebildeten Durchbrüchen versehen ist, und daß die Zwischenwand an ihrem unteren Bereich ein oder mehrere Lüfter trägt, die die Luft aus dem Zwischenraum absaugen und in den Innenraum des Schrankkorpusses zurückführen. Über die Eintrittsöffnungen strömt dann wieder Luft dem Zwischenraum zu.

Gemäß einer bevorzugten Erfindungsvariante kann es dabei vorgesehen sein, daß die Zwischenwand zwei oder mehrere Reihen von Durchbrüchen aufweist, und daß die Durch-brüche symmetrisch zu der, in der Ebene der Zwischenwand verlaufenden Mittelquer- und Mittellängsachse verteilt angeordnet sind. Hierdurch wird zum einen eine Montagevereinfachung erreicht, zum anderen läßt sich über die gleichmäßige Verteilung der Durchbrüche auch eine gleichmäßige Luftströmung und Führung in vielen Varianten erreichen.

Die Erfindung wird im folgenden anhand eines in der Zeichnung dargestellten Ausführungsbeispiels näher erläutert. Die Zeichnung zeigt in Teildarstellung und perspektivischer Seitenansicht ein Rahmengestell eines Schaltschrankes. Das Rahmengestell weist einen Boden- und einen Deckrahmen auf. Diese sind aus horizontalen Tiefen- und Breitenstreben 11 und 12 zusammengesetzt. Der Bodenrahmen ist mit dem Deckrahmen mittels vertikaler Rahmenprofile 10 verbunden. Sowohl die vertikalen Rahmenprofile 10 als auch die Tiefen- und Breitenstreben 11 und 12 sind mit Reihen von in gleicher Teilung zueinander beabstandeten Befestigungsaufnahmen 13 versehen.

Das Rahmengestell kann mittels vertikalen und horizontalen Seitenwänden 14 und wenigstens einer Schranktür verkleidet werden. Die Seitenwände 14 sind in der Regel aus einem Stahlblech gefertigt und weisen somit eine gute Wärmeleitfähigkeit auf.

In der Zeichnung ist aus Gründen der Übersichtlichkeit nur eine Seitenwand 14 dargestellt. Parallel beabstandet zu dieser und dem Schaltschrank-Innenraum zugekehrt, ist eine Zwischenwand 20 angeordnet. Die Zwischenwand 20 kann mit ihren vertikalen Rändern 28 an den Befestigungsaufnahmen 13 der vertikalen Rahmenprofile 28 angeschraubt werden (Befestigungsschrauben 21). Zwischen der Seitenwand 14 und der Zwischenwand 20 ist ein Luftsammelkanal gebildet. In diesem Luftsammelkanal ist eine als Wärmetauscher ausgebildete Klimatisierungseinrichtung eingebaut, die im vorliegenden Ausführungsbeipiel von einer mäanderförmig geführten Flüssigkeitsleitung gebildet ist. Die Flüssigkeitsleitung ist mittels zweier Rohrstücke durch die Seitenwand 14 hindurch aus dem Luftsammelkanal geführt. Hier kann sie über Anschlußstücke 23, 24 an ein Kühlsystem angeschlossen werden. Der Luftsammelkanal steht über Durchbrüche 25 der Zwischenwand 20 mit dem Schaltschrank-Innenraum in räumlicher Verbindung. Die Durchbrüche 25 sind dabei in horizontal verlaufenden Reihen angeordnet, die in verschiedenen horizontalen Ebenen angeordnet sind. Eine Reihe ist im oberen Dachbereich, eine im unteren Bodenbereich und eine dritte im Mittenbereich der Zwischenwand 20 angeordnet. Die Zwischenwand 20 ist bevorzugt symmetrisch aufgebaut, so daß eine Montagevereinfachung erreicht ist. Die Durchbrüche 25 lassen sich wahlweise mittels Abdeckplatten 27 verschließen. Im Ausführungsbeispiel sind die Durchbrüche 25 der mittleren Reihe verschlossen. Zur Anbringung der Abdeckplatten 27 sind diese mit Hakenelementen 21a versehen, die in den unteren horizontalen Rand der Durchbrüche 25 eingehangen werden können. Im Bereich des oberen horizontalen Randes lassen sich die Abdeckplatten 27 dann mit einem Befestigungselement 21 an der Zwischenwand (20) anschrauben.

An den unteren Durchbrüchen 25 sind Lüfter 32 angeordnet. Diese sind auf Adapter 30 aufgeschraubt, welche mit einer Befestigungsplatte 31 an dem Durchbruch 25 fixiert werden können.

Die Lüfter 32 saugen Luft aus dem Luftsammelkanal und geben diese in den Schaltschrank-Innenraum ab. Gleichzeitig strömt erwärmte Luft aus dem Dachbereich des Schaltschrankes durch die oberen Durchbrüche 25 in den Luftsammelkanal. Die erwärmte Luft wird an der Klimatisierungseinrichtung 22 vorbeigeführt, so daß sie sich abkühlt. Bevorzugt sind die horizontalen Leitungsabschnitte dabei quer zur Strömungsrichtung versetzt zueinander angeordnet. Die Luft kann diese dann unmströmen, wodurch eine effektive Ausnutzung der Kühlleistung möglich wird. Die gekühlte Luft wird im Anschluß an die Klimatisierungseinrichtung 22 wieder über die Lüfter 32 in den Schaltschank-Innenraum zurückgeführt.

Die Seitenwand 14 dient als zusätzlicher Wärmetauscher, über den ein großflächiger Wärmetausch mit der Umgebung möglich ist. Mit dieser einfachen Maßnahme kann mit der Klimatisierungseinrichtung 22 ein hoher Wirkungsgrad verwirklicht werden.

Die Erfindung ist nicht alleine auf das in der Zeichnung dargestellte Ausführungsbeispiel beschränkt. Es ist auch denkbar die Klimatisierungseinrichtung zwischen der mittleren und der unteren Reihe der Durchbrüche 25 einzubauen. Weiterhin kann auch zusätzlich eine weitere Klimatisierungseinrichtung 22 eingebaut sein.

Denkbar ist es auch, die Lüfter 32 an den oberen Durchbrüchen 25 anzubauen, wobei diese dann die Luft aus dem Schaltschrank-Innenraum in den Luftsammelkanal einblasen.

Aufgrund der Anordnung der Durchbrüche 25 sind vielfältige Strömungsführungen möglich, so daß eine gezielte Klimatisierung des Schaltschrank-Innenraumes ermöglicht wird.

Wenn ein Schaltschrank in einer kalten Umgebung aufgestellt wird, so läßt sich das erfindungsgemäße Kliamtisierungssystem auch zur Heizung des Schaltschrank-Innenraumes einsetzen. Als Wärmetauscher wird dann beispielsweise eine Heizschleife im Luftsammelkanal eingebaut.

## Patentansprüche

1. Schaltschrank mit einem Schrankkorpus, dessen offene Korpusseiten zumindest teilweise mit einer oder mehreren Seitenwänden (14) verschließbar sind, wobei im Bereich wenigstens einer Seitenwand (14) eine Klimatisierungseinrichtung (22) angeordnet ist, über die Wärme aus dem Innenraum des Schrankkorpusses abgeführt oder diesem zugeleitet ist,
**dadurch gekennzeichnet,**
**dass** parallel beabstandet zu der Seitenwand (14) dem Innenraum des Schrankkorpusses zugekehrt eine Zwischenwand (20) angeordnet ist,
**dass** in dem Zwischenraum, der von der Seitenwand (14) und der Zwischenwand (20) umschlossen ist, die Klimatisierungseinrichtung (22) angeordnet ist,
**dass** der Schrankkorpus ein Rahmengestell aufweist, das aus vertikalen Rahmenprofilen (10) und horizontalen Tiefen- und Breitenstreben (11 und 12) zusammengesetzt ist, und
**dass** die Zwischenwand (20) und die Seitenwand (14) an dem Rahmengestelt befestigt sind.

2. Schaltschrank nach Anspruch 1,
**dadurch gekennzeichnet,**
**dass** die in Richtung senkrecht zur Seitenwand (14) verlaufende Breite des Zwischenraumes gleich oder kleiner der vertikalen Rahmenprofile (10) oder der Tiefen- bzw. Breitenstreben (11, 12) ist.

3. Schaltschrank nach Anspruch 1 oder 2,
**dadurch gekennzeichnet,**
**daß** die Klimatisierungseinrichtung (22) als Wärmetauscher ausgebildet ist,
**daß** die Zwischenwand (20) mit einem oder mehreren Durchbrüchen (25) versehen ist, über die Luft aus dem Schaltschrank-Innenraum dem Wärmetauscher zugeleitet ist, und
**daß** die am Wärmetauscher klimatisierte Luft wieder über einen oder mehrere Durchbrüche in den Schaltschrank-Innenraum zurückgeführt ist.

4. Schaltschrank nach Anspruh 3,
**dadurch gekennzeichnet,**
**daß** der Wärmetauscher ein mäanderförmig angeordnetes Leitungssystem aufweist, durch das Kühlflüssigkeit geleitet ist, und das mit Kühlflächen in den Zwischenraum weist, und
**daß** das Leitungssystem über Anschlußstücke (23, 24) an eine außerhalb des Schrankkorpusses angeordnete Versorgungseinheit angeschlossen ist.

5. Schaltschrank nach Anspruch 4.
**dadurch gekennzeichnet,**
**daß** das Leitungssystem mit Leitungsabschnitten ausgestattet ist, die quer zur Strömungsrichtung angeordnet sind, und
**daß** die benachbarten Leitungsabschnitte senkrecht zur Seitenwand (14) gegeneinander versetzt angeordnet sind.

6. Schaltschrank nach einem der Ansprüche 1 bis 5,
**dadurch gekennzeichnet,**
**daß** die vertikale Zwischenwand (20) in ihrem oberen Bereich mit den als Eintrittsöffnungen ausgebildeten Durchbrüchen (25) versehen ist, und
**daß** die Zwischenwand an ihrem unteren Bereich ein oder mehrere Lüfter (32) trägt, die die Luft aus dem Zwischenraum absaugen und in den Innenraum des Schrankkorpusses zurückführen,

7. Schaltschrank nach einem der Ansprüche 1 bis 5,
**dadurch gekennzeichnet,**
**daß** die vertikale Zwischenwand (20) in ihrem oberen Bereich mit den als Eintrittsöffnungen ausgebildeten Durchbrüchen (25) versehen ist, und
**daß** diesen Durchbrüchen (25) Lüfter (32) zugeordnet sind, die die Luft aus dem Innenraum des Schaltschrankes absaugen und in den Zwischenraum einblasen.

8. Schaltschrank nach einem der Ansprüche 1 bis 7,
**dadurch gekennzeichnet,**
**daß** die Zwischenwand (20) zwei oder mehrere Reihen von Durchbrüchen (25) aufweist, und
**daß** die Durchbrüche (25) symmetrisch zu der, in der Ebene der Zwischenwand (20) verlaufenden Mittelquer- und Mittellängsachse verteilt angeordnet sind.

## Claims

1. Switch cabinet with a basic cabinet structure, of which open basic-structure sides can be closed off at least in part by one or more side walls (14), an air-conditioning device (22) being arranged in the region of at least one side wall (14) and channelling away heat from the interior of the basic cabinet structure, or directing heat to the same, **characterized in that** an intermediate wall (20) is spaced apart from the side wall (14), parallel thereto, such that it is directed towards the interior of the basic cabinet structure, **in that** the air-conditioning device (22) is arranged in the interspace which is enclosed by the side wall (14) and the intermediate wall (20), **in that** the basic cabinet structure has a framework which is made up of vertical frame profiles (10) and horizontal depth and width struts (11 and 12), and **in that** the intermediate wall (20) and the side wall (14) are fastened on the framework.

2. Switch cabinet according to Claim 1, **characterized in that** the interspace width running in the direction perpendicular to the side wall (14) is smaller than or equal to the vertical frame profiles (10) or the depth and width struts (11, 12).

3. Switch cabinet according to Claim 1 or 2, **characterized in that** the air-conditioning device (22) is designed as a heat exchanger, **in that** the intermediate wall (20) is provided with one or more through-passages (25), via which air is directed to the heat exchanger from the switch-cabinet interior, and **in that** the air conditioned in the heat exchanger is channelled back into the switch-cabinet interior again via one or more through-passages.

4. Switch cabinet according to Claim 3, **characterized in that** the heat exchanger has a meandering line system through which cooling liquid is directed and which has cooling surfaces oriented in the direction of the interspace, and **in that** the line system is connected, via connection elements (23, 24), to a supply unit arranged outside the basic cabinet structure.

5. Switch cabinet according to Claim 4, **characterized in that** the line system is provided with line sections which are arranged transversely to the flow direction, and **in that** the adjacent line sections are offset in relation to one another perpendicularly to the side wall (14).

6. Switch cabinet according to one of Claims 1 to 5, **characterized in that** the vertical intermediate wall (20) is provided with the through-passages (25), designed as inlet openings, in its top region, and **in that** the intermediate wall bears one or more fans (32) in its bottom region, said fans extracting the air by suction from the interspace and channelling it back into the interior of the basic cabinet structure.

7. Switch cabinet according to one of Claims 1 to 5, **characterized in that** the vertical intermediate wall (20) is provided with the through-passages (25), designed as inlet openings, in its top region, and **in that** said through-passages (25) are assigned fans (32) which extract the air by suction from the interior of the basic cabinet structure and blow it into the interspace.

8. Switch cabinet according to one of Claims 1 to 7, **characterized in that** the intermediate wall (20) has two or more rows of through-passages (25), and **in that** the through-passages (25) are distributed symmetrically to the centre transverse axis and centre longitudinal axis running in the plane of the intermediate wall (20).

## Revendications

1. Armoire de commande avec un corps d'armoire, dont les côtés ouverts du corps peuvent être fermés au moins en partie avec une ou plusieurs parois latérales (14), dans laquelle un dispositif de climatisation (22) est disposé dans la région d'au moins une paroi latérale (14), par l'intermédiaire duquel de la chaleur est extraite de l'espace intérieur du corps d'armoire ou est fournie à celui-ci, **caractérisée en ce qu'**une cloison (20) tournée vers l'espace intérieur du corps d'armoire est disposée parallèlement à distance de la paroi latérale (14), **en ce que** le dispositif de climatisation (22) est disposé dans l'espace intermédiaire qui est délimité par la paroi latérale (14) et la cloison (20), **en ce que** le corps d'armoire présente une baie, qui est composée de profilés de cadre verticaux (10) et d'entretoises horizontales de profondeur et de largeur (11 et 12), et **en ce que** la cloison (20) et la paroi latérale (14) sont fixées à la baie.

2. Armoire de commande suivant la revendication 1, **caractérisée en ce que** la largeur de l'espace intermédiaire orientée dans une direction perpendiculaire à la paroi latérale (14) est égale ou inférieure à celle des profilés de cadre verticaux (10) ou des entretoises de profondeur, respectivement de largeur (11, 12).

3. Armoire de commande suivant la revendication 1 ou 2, **caractérisée en ce que** le dispositif de climatisation (22) est constitué par un échangeur de chaleur, **en ce que** la cloison (20) est pourvue d'une ou de plusieurs ouvertures (25), par lesquelles l'air provenant de l'espace intérieur de l'armoire de commande est envoyé à l'échangeur de chaleur, et **en ce que** l'air conditionné dans l'échangeur de chaleur est à nouveau renvoyé dans l'espace intérieur de l'armoire de commande par une ou plusieurs ouvertures.

4. Armoire de commande suivant la revendication 3, **caractérisée en ce que** l'échangeur de chaleur présente un réseau de conduites de configuration sinueuse, à travers lequel circule un fluide de refroidissement et qui présente des faces de refroidissement vers l'espace intermédiaire, et **en ce que** le réseau de conduites est raccordé, par des pièces de raccordement (23, 24), à une unité d'alimentation disposée à l'extérieur du corps d'armoire.

5. Armoire de refroidissement suivant la revendication 4, **caractérisée en ce que** le réseau de conduites est équipé de portions de conduites, qui sont disposées transversalement à la direction d'écoulement, et **en ce que** les portions de conduites voisines sont disposées perpendiculairement à la paroi latérale (14) avec un décalage l'une par rapport à l'autre.

6. Armoire de commande suivant l'une quelconque des revendications 1 à 5, **caractérisée en ce que** la cloison verticale (20) est pourvue, dans sa région supérieure, des ouvertures (25) sous la forme d'ouvertures d'entrée, et **en ce que** la cloison porte dans sa région inférieure un ou plusieurs ventilateurs (32), qui aspirent l'air hors de l'espace intermédiaire et le renvoient dans l'espace intérieur du corps d'armoire.

7. Armoire de commande suivant l'une quelconque des revendications 1 à 5, **caractérisée en ce que** la cloison verticale (20) est pourvue, dans sa région supérieure, des ouvertures (25) sous la forme d'ouvertures d'entrée, et **en ce qu'**à ces ouvertures (25) sont associés des ventilateurs (32), qui aspirent l'air hors de l'espace intérieur de l'armoire de commande et l'insufflent dans l'espace intermédiaire.

8. Armoire de commande suivant l'une quelconque des revendications 1 à 7, **caractérisée en ce que** la cloison (20) présente deux ou plus de deux rangées d'ouvertures (25), et **en ce que** les ouvertures (25) sont disposées en une répartition symétrique par rapport à l'axe central transversal et à l'axe central longitudinal situés dans le plan de la cloison (20).
